(19) Europäisches Patentamt / European Patent Office / Office européen des brevets

(11) **EP 4 708 688 A1**

(12) **EUROPEAN PATENT APPLICATION**

(43) Date of publication:
**11.03.2026 Bulletin 2026/11**

(21) Application number: **25199389.5**

(22) Date of filing: **01.09.2025**

(51) International Patent Classification (IPC):
**H03H 7/01** $^{(2006.01)}$   **H03H 7/38** $^{(2006.01)}$
**H03H 7/48** $^{(2006.01)}$   **H03F 1/02** $^{(2006.01)}$
**H03F 3/21** $^{(2006.01)}$   **H03H 7/06** $^{(2006.01)}$

(52) Cooperative Patent Classification (CPC):
**H03H 7/0115; H03F 1/0288; H03F 3/19;**
**H03F 3/211; H03H 7/0153; H03H 7/06;**
**H03H 7/1733; H03H 7/38; H03H 7/48;**
H03F 2200/451; H03H 2007/386; H03H 2210/025;
H03H 2210/036

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **03.09.2024 US 202418822540**

(71) Applicant: **NXP USA, Inc.**
**Austin, TX 78735 (US)**

(72) Inventors:
• **HOOGZAAD, Gian**
  **5656AG Eindhoven (NL)**
• **YANG, Xin**
  **5656AG Eindhoven (NL)**
• **ACAR, Mustafa**
  **5656AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire SO51 9NJ (GB)**

(54)   **PROGRAMMABLE POWER SPLITTER CIRCUITS AND METHODS**

(57)   A device includes a splitter circuit including a first port configured to receive an input signal, a second port configured to provide a first output signal, and a third port configured to provide a second output signal. The splitter circuit includes an inductor including a first terminal coupled to the first port and a second terminal coupled to ground, a first capacitor circuit including a first terminal coupled to the first port and a second terminal coupled to the second port, a second capacitor circuit including a first terminal coupled to the first port and a second terminal coupled to the third port, and an isolation impedance coupled between the second port and the third port. The first capacitor circuit and the second capacitor circuit are programmable to provide a selected power-power split ratio between the first output signal and the second output signal.

FIG. 3

EP 4 708 688 A1

## Description

FIELD OF USE

The present disclosure generally relates to power splitter circuits and methods, and more particularly to power splitter circuits used to divide power for transistors of a power amplifier.

BACKGROUND

Power efficiency is important for Power Amplifiers (PAs) in wireless infrastructure base stations. The Doherty PA is ubiquitous within cellular base station transmitters because the Doherty PA architecture is known to improve back-off efficiency for spectrally efficient modulations, when compared with other types of amplifiers. The high efficiency of the Doherty PA makes the architecture desirable for current and next-generation wireless systems.

BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.

FIG. 1 depicts a block diagram of a portion of a system including a Doherty amplifier including a programmable power splitter between a driver and a final stage, in accordance with certain embodiments of the present disclosure.

FIG. 2A depicts a diagram of a programmable splitter circuit including an isolation impedance provided by inductor and resistor in series, in accordance with certain embodiments of the present disclosure.

FIG. 2B depicts a diagram of a programmable splitter circuit including an isolation impedance provided by inductor and resistor in parallel, in accordance with certain embodiments of the present disclosure.

FIG. 3 depicts a diagram of a programmable splitter circuit including an isolation impedance provided by inductor and resistor in series, in accordance with certain embodiments of the present disclosure.

FIG. 4 depicts a graph of nominal performance plots of magnitude in decibels versus frequency in gigahertz for a programmable capacitor-inductor splitter, in accordance with certain embodiments of the present disclosure.

FIG. 5 depicts a graph of nominal performance plots of magnitude in decibels versus frequency in gigahertz for a programmable capacitor-inductor splitter where the port impedances are held constant while the capacitances are changed in opposite directions, in accordance with certain embodiments of the present disclosure.

FIG. 6 depicts a graph of the nominal performance plots of magnitude in decibels versus frequency in gigahertz for a programmable capacitor-inductor splitter where the programmable capacitor network enables 0.5 dB steps, in accordance with certain embodiments of the present disclosure.

FIG. 7 depicts a graph of a graph of the nominal performance plots of magnitude in decibels versus frequency in gigahertz for a programmable capacitor-inductor splitter where the programmable capacitor network enables 0.25 dB steps, in accordance with certain embodiments of the present disclosure.

FIG. 8 depicts a flow diagram of a method 800 of splitting power provided to main and peak amplifiers of a Doherty amplifier, in accordance with certain embodiments of the present disclosure.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

DETAILED DESCRIPTION

Power efficiency is important for power amplifiers (PAs), which may be used, for example, in wireless infrastructure base stations. Power efficiency is pursued in various ways, such as using proven efficient Doherty PA topologies. Doherty PAs include a splitter circuit to divide power between a pair of transistors (a main transistor and a peaking transistor). In Doherty PA topologies in which the splitter circuit is between the driver circuit and the final stage that includes the transistors, a small loss in the splitter circuit negatively impacts the output of the PA.

Embodiments of circuits and methods are described below that include a programmable splitter circuit configured to use reactive components (transistors, capacitors, and inductors) to provide the power splitting function and to use an isolation resistor and an isolation inductor to absorb reflected power in case of an output mismatch and to provide power matching and isolation between the outputs. In one or more embodiments, one or more of the power-split ratio or the phase difference of the splitter circuit may be programmed or adjusted to enable various functions. In one or more embodiments, one or more of the power-split ratio or the phase difference of the splitter circuit may be adjusted based on process spread, ageing spread, assembly spread (of Gallium-Nitride transistors, bond wires, or other circuit structures), or any combination thereof.

In one or more embodiments, one or more of the power-split ratio or the phase difference of the splitter circuit may be programmed to adapt to signals with varying peak-to-average ratios (e.g., 7.5 decibels (dB) to 9 dB). In one or more embodiments, one or more of the power-split ratio or the phase difference of the splitter circuit may be programmed to optimize the phase and power split during load trafficking and night operation or when the transmitting system (e.g., a wireless infrastructure base station) is required to transmit less power. In one or more embodiments, low-power transmission may be achieved by decreasing a supply voltage, which may change the input impedance of the Doherty PA, and the power-split ratio and the phase difference of the splitter circuit may be adjusted to improve the efficiency of the Doherty PA at the decreased supply voltage level.

In one or more embodiments, the splitter circuit may be programmable over a selected range of power ratios, measured in decibels. In one or more embodiments, the programmable power ratio may vary within a range from zero (0) dB to approximately four (4) dB or within a different range. In an embodiment where the main transistor and the peaking or carrier transistor receive equal power, the splitter circuit may provide power to both transistors with approximately zero (0) dB difference. In one or more embodiments, the splitter circuit may be programmed to provide more power to the peaking or carrier transistor than to the main transistor, such as two decibels, four decibels, an intermediate decibel level, and so on. In one or more embodiments, the ratio may be varied by any number of increments within a selected range.

In one or more embodiments, the splitter circuit may include one or more programmable capacitors. In one or more embodiments, the programmable capacitors may be DC-voltage controlled capacitors. In one or more embodiments, the splitter circuit may include a capacitor bank using switches and a control circuit configured to selectively couple capacitors of the capacitor bank in parallel to provide a selected capacitance to enable a selected power-split ratio at the outputs of the splitter circuit.

In one or more embodiments, the splitter circuit may enable a programmable power-split ratio, may be "lossless" or may have a low power loss, and may have a small size and low cost to implement. In one or more embodiments, the splitter circuit may provide a relatively high isolation and return loss bandwidth that may be greater than two gigahertz. In one or more embodiments, the splitter circuit may demonstrate high linearity with a third-order intercept point (IP3) greater than 50 dBm. In one or more embodiments, the splitter circuit may be configured to enable fast switching times of less than 100 nanoseconds.

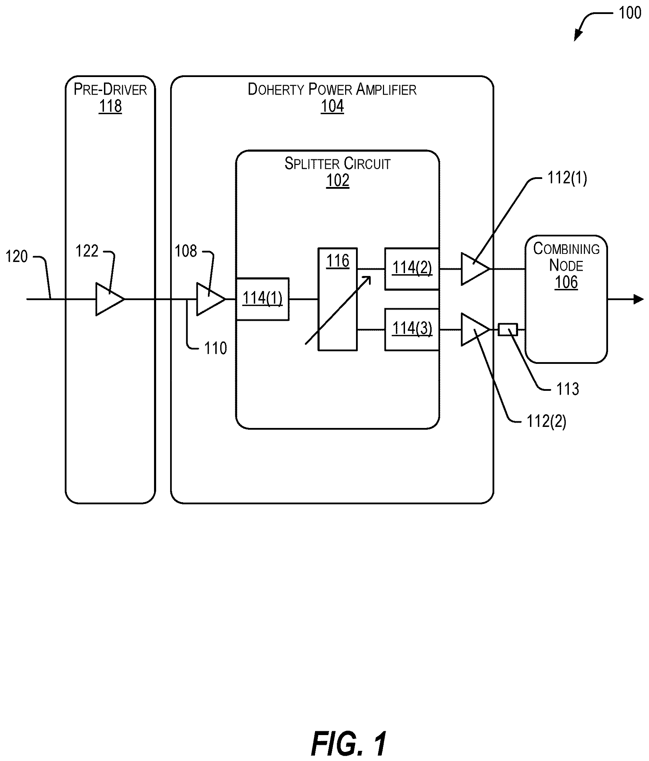

In one or more embodiments, a device may include an inductor including a first terminal coupled to an input node and a second terminal coupled to ground. The device may include a first programmable capacitor circuit coupled between the input node and a first output node and a second programmable capacitor circuit coupled between the input node and a second output node. The device may include a resistor and an inductor coupled in series or in parallel between the first output node and the second output node for output matching and output-to-output isolation. In one or more embodiments, the device may include or may be coupled to a control circuit configured to control the first and second programmable capacitor circuits to provide a selected power split between the first output node and the second output node. In one or more embodiments, each of the programmable capacitor circuits may include switchable capacitor banks that may be responsive to signals from the control circuit to provide a selected capacitance. An embodiment of a programmable splitter device used in a Doherty amplifier system is described below with respect to FIG. 1.

FIG. 1 depicts a block diagram of a portion of a system 100 including a Doherty power amplifier (PA) 104 including a programmable power splitter 102 between a driver 108 and a final stage, in accordance with certain embodiments of the present disclosure. The PA 104 may include the driver 108 including an input coupled to an input node 110 and an output coupled to a node 114(1) of the splitter circuit 102. The PA 104 may include a first (main) amplifier 112(1) including an input coupled to a node 114(2) of the splitter circuit 102 and an output coupled to a combining node 106. The PA 104 may include a second (peak or peaking) amplifier 112(2) including an input coupled to a node 114(3) of the splitter circuit 102 and an output coupled to the combining node 106 optionally through a phase delay and impedance inversion element 113.

According to various Doherty power amplifier embodiments, each of the carrier amplifier 112(1) and the peaking amplifier 112(2) may be implemented as one or more amplifier dies (i.e., integrated circuit (IC) or power transistor bearing semiconductor dies), packaged in a surface-mount type of package. In one or more embodiments, the package leads may enable a very compact impedance inverter line to be utilized. More specifically, the package leads may be used to provide portions of the phase delay and impedance inversion element 113, for example, providing a minimum phase 90-degree inverter between the output of the second amplifier 112(2) and the combining node 106, which may be implemented as a combiner circuit.

In one or more embodiments, the series-coupled assembly may include electrical connections (e.g., wire bonds) between the output of the first amplifier 112(1), the output of the second amplifier 112(2), package leads, and an impedance inverter line. This "assembly" may be referred to herein as an impedance inverter and Doherty load modulation assembly, or more concisely as an "impedance inverter line assembly".

The first (carrier or main) amplifier 112(1) and the second (peak or peaking) amplifier 112(2) may each be implemented using a single-stage or multiple-stage power amplifier including one or more transistor integrated circuit (IC) dies. A single-stage power amplifier may include a single power transistor, and a multiple-stage power amplifier may include, at least, a driver transistor in series with a final-stage transistor. As used herein, when the amplifier 112 (e.g., the carrier or peaking amplifier) is a single-stage power amplifier, the single transistor stage may be considered a "final-stage" transistor. Using nomenclature typically applied to field effect transistors (FETs), on the input side, the carrier amplifier 112(1) and the peaking amplifier 112(2) each may include a transistor (e.g., a driver transistor and/or final-stage transistor) with an input/control terminal (e.g., a gate) configured to receive an RF input signal, and on the output side, the carrier amplifier 112(1) and the peaking amplifier 112(2) each may include a final-stage transistor with two current conducting terminals (e.g., a drain terminal and a source terminal). In some configurations, each source terminal is coupled to a ground reference voltage node, and the amplified carrier and peaking signals are provided at the drain terminals (or outputs) of the final-stage carrier amplifier transistor and the final-stage peaking amplifier transistor, respectively.

In a "non-inverting" Doherty power amplifier embodiment (also referred to as a "classical" Doherty, a "90-0" Doherty, or a "0-90" Doherty), phase shift(s) may be applied to the input RF signal(s) so that the phase of the RF signal provided to the peaking amplifier 112(2) lags the phase of the RF signal provided to the carrier amplifier 112(1) by about 90 degrees. In other words, with respect to the input RF signal to the carrier amplifier 112(1), the input RF signal to the peaking amplifier 112(2) may have a phase lag of about 90 degrees. In such embodiments, the inverter line assembly may apply about a 90-degree phase shift (and an impedance inversion) to the amplified carrier signal before it is combined with the amplified peaking signal at the combining node (combining node 106), whereas no substantial phase shift is applied to the amplified peaking signal before it reaches the combining node.

To provide a 90-degree phase shift and an impedance inversion between the drain terminal of the carrier amplifier 112(1) and the combining node (e.g., at the drain terminal of the peaking amplifier 112(2) final-stage transistor), the drain terminal of the final-stage carrier amplifier transistor may be electrically coupled to the first end of an embodiment of an impedance inverter line assembly, and the second end of the impedance inverter line assembly may be electrically coupled to the drain terminal of the final-stage peaking amplifier 112(2) transistor (i.e., the combining node or combining node 106). The electrical length of the impedance inverter line assembly between the drain terminals of the carrier amplifier 112(1) and peaking amplifier 112(2) final-stage transistors is determined by the parasitic drain-source capacitances of the carrier and peaking amplifier transistors, the electrical length of an impedance inverter line (e.g., a transmission line) extending between the carrier and peaking amplifier transistor drain terminals, and the electrical lengths of any additional series conductive structures between the drain terminals and the ends of the impedance inverter line.

In a 90-0 Doherty amplifier, because the drain-source capacitances and the electrical lengths of the additional series conductive structures are non-trivial, the electrical length of the impedance inverter line in an impedance inverter line assembly will have a value that is less than 90 degrees. In various embodiments, depending on the fundamental frequency of operation, f0, of the Doherty amplifier and the characteristics of the connections to the ends of the impedance inverter line, the electrical length of the impedance inverter line may have a value in the range of about 10 degrees to about 70 degrees, although the electrical length of the impedance inverter line may be smaller or larger, as well. At higher fundamental operational frequencies, the electrical length translates into a very short physical length for the impedance inverter line.

The combining node 106 may include a first input coupled to the output of the first amplifier 112(1), a second input coupled to the output of the second amplifier 112(2), and an output. The combining node 106 may include phase delays and a node at which the signal from the output of the first amplifier 112(1) and the signal from the output of the second amplifier 112(2) are added together to produce a combined output signal.

The splitter circuit 102 may include a first port 114(1) coupled to the output of the driver 108, a second port 114(2) coupled to the input of the first amplifier 112(1), and a third port 114(3) coupled to the input of the second amplifier 112(2). The splitter circuit 102 may include a programmable splitter 116 configured to enable a programmable power split ratio. The programmable splitter 116 may be configured to receive a signal from the driver 108 via the first port 114(1), divide the received signal into a first signal having a first power level and a second signal having a second power level, and provide the first signal to the second port 114(2) and the second signal to the third port 114(3). The programmable splitter 116 may be controlled to provide the first signal and the second signal such that the first power level and the second power level have a selected power-split ratio that may be programmable within a range of power levels.

In one or more embodiments, the programmable splitter 116 may provide the first signal and the second signal having power levels that are approximately equal, such that the power-split ratio is approximately zero decibels. In one or more embodiments, the programmable splitter 116 may be controlled to provide the first and second signals having a power-split ratio that varies between zero decibels and four decibels or more. In one or more embodiments, the programmable splitter 116 may be controlled to provide power-split ratios having any number of incremental variations between zero decibels and four or more decibels. In an example, the programmable splitter 116 may enable power-split ratios that half-decibel incremental steps, quarter-decibel incremental steps, or other incremental steps.

In the illustrated example, the system 100 may include a pre-driver circuit 118 including a pre-driver input 120 to receive a signal. The pre-driver circuit 118 may include an amplifier 122 including an input coupled to the pre-driver input 120 and an output coupled to the input node 110 of the Doherty PA 104. In one or more embodiments, the pre-driver circuit 118 may be omitted.

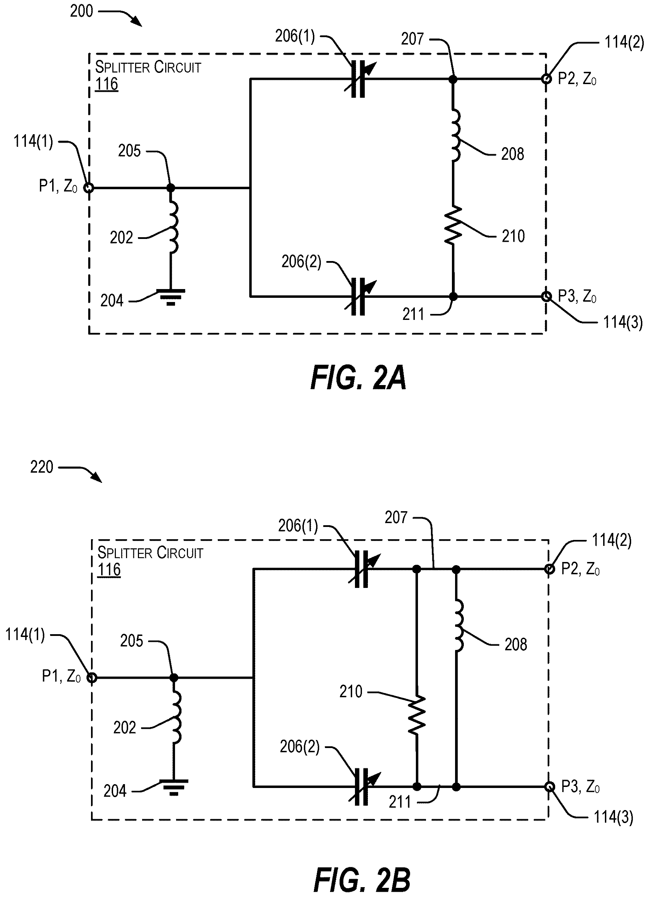

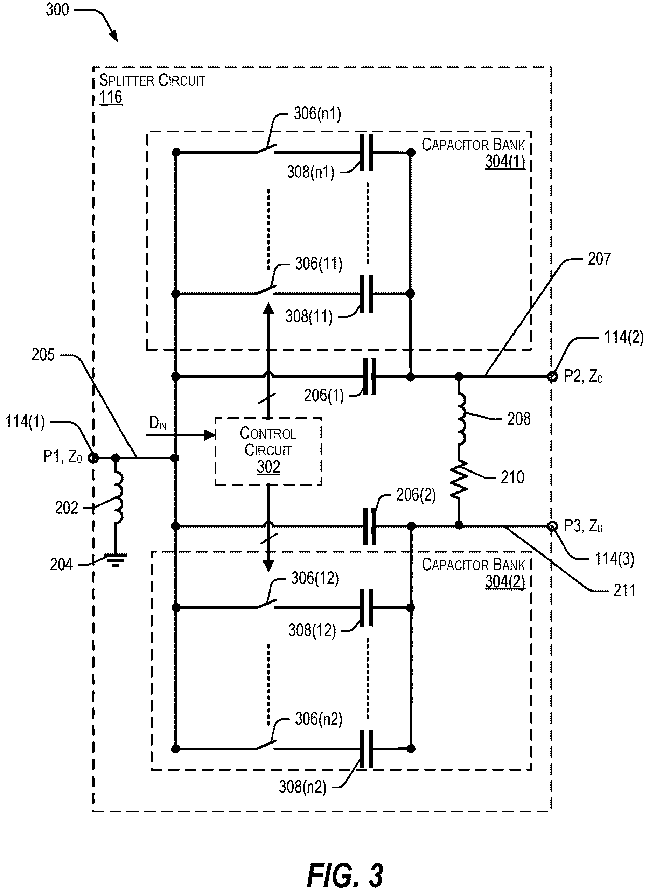

In one or more embodiments, the splitter circuit 102 may be designed with an impedance up-conversion from output to input. In principle, per arm of the splitter circuit 102, a capacitor-inductor up-converter may be included. In one or more embodiments, as shown below with respect to FIGs. 2A, 2B, and 3, the inductor may be located at a common point and may be in parallel with the isolation inductor, so the inductance may be designed as a single component with half of the inductance, which is beneficial for both size and cost.

As discussed below, the isolation impedance may be implemented with a resistor and an inductor in series or in parallel. Examples of programmable splitters 102 are described below with respect to FIGs. 2A and 2B.

FIG. 2A depicts a diagram of an embodiment of a circuit 200 including a programmable splitter circuit 116 including an isolation impedance provided by inductor 208 and resistor 210 in series, in accordance with certain embodiments of the present disclosure. The programmable splitter circuit 116 may include an inductor 202 including a first terminal coupled to a node 205 and a second terminal coupled to ground 204 or another supply voltage (e.g., Vdd or an RF ground). In an example, the inductor 202 may be the choke inductor for the driver.

The node 205 may be coupled to the first port 114(1). The splitter circuit 116 may include a first programmable capacitor circuit 206(1) including a first terminal coupled to the node 205 and a second terminal coupled to a node 207, which may be coupled to the second port 114(2). The splitter circuit 116 may include a second programmable capacitor circuit 206(2) including a first terminal coupled to the node 205 and a second terminal coupled to a node 211, which may be coupled to the third port 114(3). The isolation impedance may include the inductor 208 including a first terminal coupled to the node 207 and including a second terminal. The isolation impedance may also include the resistor 210 including a first terminal coupled to the second terminal of the inductor 208 and including a second terminal coupled to the node 211. In the illustrated embodiment, the inductor 202 and the isolation inductor 208 may be implemented as integrated spiral inductors on or within the semiconductor substrate.

In one or more embodiments, the splitter circuit 116 is configured as a high-pass (HP) filter circuit and includes two signal paths coupled to the single port or port 114(1) with a first capacitor circuit 206(1) in series with the first signal path between the first port 114(1) and the second port 114(2) and a second capacitor circuit 206(2) in series with the second signal path between the first port 114(1) and the third port 114(3). The shunt inductor 202 may service a dual purpose of functioning as an electrostatic discharge coil as well as part of the high-pass filter circuit that includes the capacitor circuits 206(1). The shunt inductor 202 as well as a series-coupled inductor 208 and isolation resistance 210 may isolate receive signals or transmit signals on the two paths for the ports 114(2) and 114(3).

In one or more embodiments, the capacitor circuits 206 may be independently controlled or programmed to provide a selected capacitance for each signal path to provide a selected power-split ratio between the two signal paths. The capacitor circuits 206 may be implemented as voltage-controlled circuits or may be implemented as selectable capacitor bank circuits that may be controlled to provide selected capacitances.

In one or more embodiments, the splitter circuit 116 in the diagram 200 may be implemented with the port impedance $Z_0$ for each port 114 being equal and with an equal power split (0 dB splitter ratio) between the ports 114(2) and 114(3). In such an implementation, the input inductance $L_{in}$ may be determined as follows:

$$L_{in} = \frac{Z_0}{\omega} = \frac{Z_0}{2\pi f} \tag{1}$$

where the variable $\omega$ represents the angular frequency, which is equal to the frequency $f$ multiplied by two times pi. The input capacitance $C_{in}$ is inversely proportional to the angular velocity $\omega$ and the port impedance $Z_0$ as follows:

$$C_{in} = \frac{1}{\omega Z_0}. \tag{2}$$

The isolation inductance $L_{iso}$ of the inductor 208 may be determined as follows:

$$L_{iso} = \frac{Z_0}{\omega}. \tag{3}$$

The isolation resistance $R_{iso}$ of the resistor 210 may be determined as follows:

$$R_{iso} = Z_0. \tag{4}$$

In the embodiment of FIG. 2A, the isolation impedance is provided by the inductor 208 and the resistor 210 arranged in series between the output ports 114(1) and 114(2). In other embodiments, the isolation impedance may be provided by other components or by another configuration of the inductor 208 and the resistor 210. An embodiment of a splitter circuit 116 that includes the inductor 208 and the resistor 210 arranged in parallel is described below with respect to FIG. 2B.

FIG. 2B depicts a diagram 220 of a programmable splitter circuit 116 including an isolation impedance provided by inductor 208 and resistor 210 in parallel, in accordance with certain embodiments of the present disclosure. The splitter circuit 116 of FIG. 2B has the same elements as the diagram 200 of FIG. 2A, except that the isolation impedance is provided by the inductor 208 and the resistor 210 arranged in parallel between the node 207 and the node 211.

In one or more embodiments, the splitter circuit 116 in the diagram 220 may be implemented with the port impedance $Z_0$ for each port 114 being equal and with an equal power split (0 dB splitter ratio) between the ports 114(2) and 114(3). In such an implementation, as in Equation 1 above, the input inductance $L_{in}$ may be determined as follows:

$$L_{in} = \frac{Z_0}{\omega} \tag{5}$$

where the variable $\omega$ represents the angular frequency, which is equal to the frequency $f$ multiplied by two times pi. As in Equation 2 above, the input capacitance $C_{in}$ is inversely proportional to the angular velocity $\omega$ and the port impedance $Z_0$ as follows:

$$C_{in} = \frac{1}{\omega Z_0}. \tag{6}$$

The isolation inductance $L_{iso}$ of the inductor 208 may be determined as follows:

$$L_{iso} = \frac{2Z_0}{\omega}. \tag{7}$$

The isolation resistance $R_{iso}$ of the resistor 210 may be determined as follows:

$$R_{iso} = 2Z_0. \tag{8}$$

In an embodiment, with an input impedance of 50Ω and a frequency of 3.6 gigahertz (GHz), the input inductance $L_{in}$ may be 2.21 nanohenries (nH), and the input capacitance $C_{in}$ may be approximately 884 femtofarads (fF). The isolation impedances $L_{iso}$ and $R_{iso}$ are twice as large for the parallel implementation as compared to the series implementation. For the relatively large isolation inductance $L_{iso}$, this means the isolation inductance $L_{iso}$ is approximately 2.21nH for the series implementation, and approximately 4.42nH for the parallel implementation.

In one or more embodiments, the variable capacitors 206 may be implemented using a capacitor bank or circuit that may be controlled to provide a selected capacitance, which may be the same or different between the signal paths from the port 114(1) to the ports 114(2) and 114(3). An embodiment of a splitter circuit 116 including switchable capacitor banks is described below with respect to FIG. 3.

FIG. 3 depicts a diagram of a system 300 including programmable splitter circuit 116 including an isolation impedance provided by inductor 208 and resistor 210 in series, in accordance with certain embodiments of the present disclosure. The programmable splitter circuit 116 may include an inductor 202 including a first terminal coupled to a node 205 and a second terminal coupled to ground 204 or another supply voltage (e.g., Vdd or an RF ground). In an example, the inductor 202 may be the choke inductor for the driver. The splitter circuit 116 may include the ports 114(1), 114(2), and 114(3). A shunt inductor 202 may be coupled between ground and a node 205, which is coupled to the port 114(1). A first signal path from the node 205 to the second port 114(2) may include a capacitor 206(1) and optionally one or more capacitors 308 of a first capacitor bank 304(1). A second signal path from the node 205 to the third port 114(3) may include a capacitor 206(2) and optionally one or more capacitors 308 of a second capacitor bank 304(2).

The capacitor 206(1) may include a first terminal coupled to the node 205 and a second terminal coupled to the node 207, which is coupled to the port 114(2). The first capacitor bank 304(1) may include a plurality of switches 306, each of which may include a first terminal coupled to the node 205, a control terminal coupled to a control circuit 302 to receive a control signal, and a second terminal. The first capacitor bank 304(1) may include a plurality of capacitors 308, each of which may include a first terminal coupled to the second terminal of one of the switches 306 of the first capacitor bank 304(1) and a second terminal coupled to the node 207.

The capacitor 206(2) may include a first terminal coupled to the node 205 and a second terminal coupled to the node 211, which is coupled to the port 114(3). The second capacitor bank 304(2) may include a plurality of switches 306, each of which may include a first terminal coupled to the node 205, a control terminal coupled to a control circuit 302 to receive a control signal, and a second terminal. The second capacitor bank 304(2) may include a plurality of capacitors 308, each of which may include a first terminal coupled to the second terminal of one of the switches 306 of the second capacitor bank 304(2) and a second terminal coupled to the node 211.

Each of the capacitor banks 304 may include a number n of branches, each of which may include a switch 306 in series with a capacitor 308 between the node 205 and one of the node 207 or 211. The switches 306 may include radio frequency (RF) switches implemented with one or more field-effect transistor (FET) devices, such as metal-oxide semiconductor FETs (MOSFETs) in RF silicon-on-insulator (SOI) technology. In one or more embodiments, each switch 306 may have a small, non-zero Figure of Merit (FOM) as follows:

$$FoM = RDS_{on} \times CDS_{off} \tag{11}$$

where RDS represents the drain-to-source on-resistance and CDS represents the drain-to-source off-capacitance. Thus, the off-state branches may capacitively load the capacitor bank with the series connection of the $CDS_{off}$ of the switch 306 and the capacitor 308. This off-state capacitive loading may be compensated by using proportionally smaller capacitors 306. In one or more embodiments, the switches 306 may be implemented using 100 fF FoM switches, which may have a drain-to-source on-resistance $RDS_{on}$ of approximately ten ohms and a drain-to-source off-capacitance $CDS_{off}$ of ten femtofarads. The size of the capacitors 306 may be reduced, given the size of capacitors 206(1) and 206(2) may be approximately 884.0 fF, 558 fF, or another value.

The system 300 includes the control circuit 302, which is shown in phantom because it may be included within the splitter circuit 116 or may be external to the splitter circuit 116. In the illustrated embodiment, the control circuit 302 may receive a digital input signal $D_{in}$, which may include instructions or settings to instruct the control circuit 302 to provide signals to selectively activate one or more of the switches 306 of the first capacitor bank 304(1), to selectively activate one or more of the switches 306 of the second capacitor bank 304(2), or any combination thereof. In one or more embodiments, each of the switches 306 of the first capacitor bank 304(1) may be independently controlled to selectively couple an associated one of the capacitors 308 in parallel with the capacitor 206(1) to present a selected impedance. In one or more embodiments, each of the switches 306 of the second capacitor bank 304(2) may be independently controlled to selectively couple an associated one of the capacitors 308 in parallel with the capacitor 206(2) to provide a selected impedance.

In one or more embodiments, the control circuit 302 may be configured to control the capacitors 308 of the first and second capacitor banks 304(1) and 304(2) symmetrically about a chosen nominal capacitance such that when the capacitance of one signal path is increased, the other is decreased so that the power-split ratio is changed without dissipating the energy. In one or more embodiments, the control circuit 302 may be configured to control the first capacitor bank 304(1) independently of the second capacitor bank 304(2), enabling further variations in the power-split ratio. In one or more embodiments, the control circuit may be configured to control the capacitors 308 of the first and second capacitor banks 304(1) and 304(2) asymmetrically about a chosen nominal capacitance, provided by capacitors 206(1) and 206(2), which may provide a minimal capacitance selected to implement the programming range and do not need to be (but still may be) programmable in this embodiment.

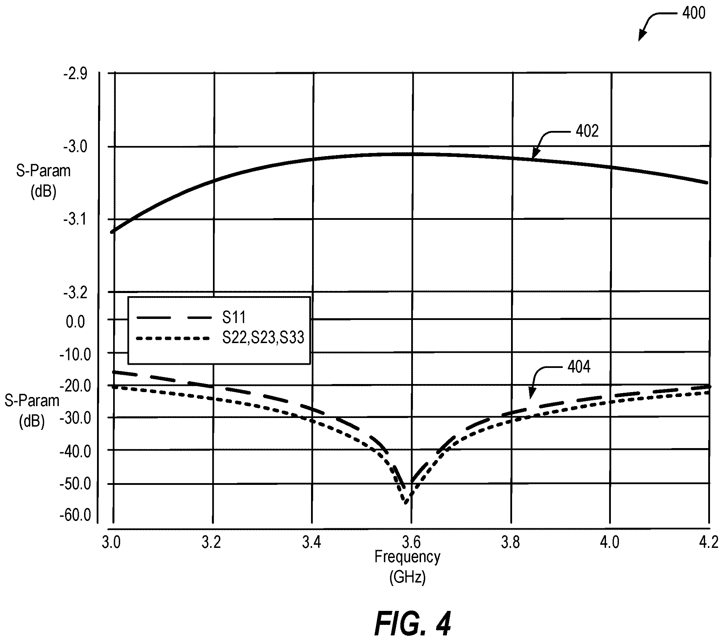

In the illustrated embodiment, the isolation impedance is depicted with the inductor 208 and the resistor 210 arranged in series between the node 207 and the node 211. In an alternative embodiment, the isolation impedance may be implemented with the inductor 208 and the resistor 210 arranged in parallel between the node 207 and the node 211. The isolation impedance may be the same for both implementations at 3.6GHz, but the behavior of the output match and the output-to-output isolation over frequency may be slightly different between the two embodiments. In one or more embodiments, the isolation bandwidth may be slightly better for the series implementation (shown in FIG. 2A and 3), while the output match bandwidth may be slightly better for the parallel implementation (shown in FIG. 2B). An example of the nominal performance plots (output match and output-to-output) for both implementations over a range of frequencies from 3.0 to 4.2 GHz are shown with respect to FIG. 4.

FIG. 4 depicts a graph 400 of nominal performance plots of magnitude in decibels versus frequency in gigahertz for a programmable capacitor-inductor splitter, in accordance with certain embodiments of the present disclosure. In the embodiments of the splitter circuits 116 for the two implementations used to produce the graph 400, the splitter circuit 116 included an input impedance of 50Ω and was operated across a frequency range of 3.0 GHz to 4.2 GHz. The input inductance $L_{in}$ may be 2.21 nanohenries (nH), and the input capacitance $C_{in}$ may be approximately 884 femtofarads (fF). The isolation impedances $L_{iso}$ and $R_{iso}$ are twice as large for the parallel implementation as compared to the series implementation. For the relatively large isolation inductance $L_{iso}$, this means the isolation inductance $L_{iso}$ is approximately 2.21nH for the series implementation, and approximately 4.42nH for the parallel implementation.

In this example, the graph 400 shows the input-to-output return losses 402 when the power split ratio between the first signal path (node 205 to node 207) and the second signal path (nod 205 to node 211) is zero decibels (0 dB). Only one line is visible because the difference between the signal paths is zero decibels, amounting to a lossless transfer from the input to the output.

The graph 400 shows the output-to-output isolation 404 in which the isolation bandwidth is slightly better for the series implementation as compared to the parallel implementation.

The control circuit 302 may control the power-split of the splitter circuit 112 may be implemented in programmable capacitors 206 or the programmable capacitor banks 304. In one or more embodiments, the control circuit 302 may adjust the programmable capacitor banks 304, the programmable capacitors 206, or both, symmetrically around a chosen nominal capacitance in such a way that one capacitance is increased to increase the power to that signal path while the other capacitance is decreased to provide less power to that signal path.

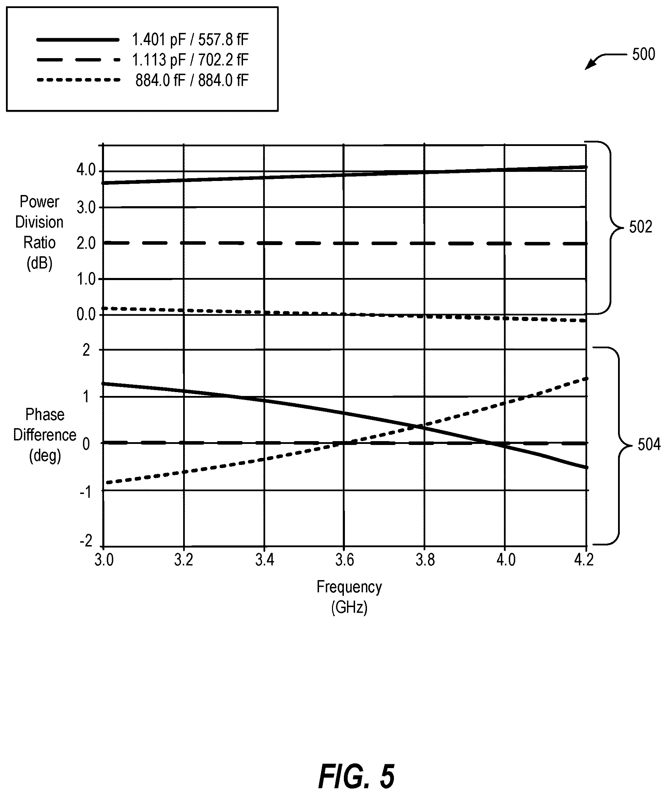

A conventional Doherty PA may have a power-split ratio requirement of 2dB ± 2dB. The nominal design of a conventional Doherty PA may have unequal capacitors and unequal output port impedances, reflecting the nominal 2dB power-split ratio. In an example, a first signal path may have a 2dB lower impedance (e.g., 40Ω) as compared to the second signal path, which has a 2dB higher impedance (e.g., 63Ω). The capacitance of the first signal path may be 2dB larger (e.g., 1113 fF), while the capacitance of the second signal path may be 2dB smaller (e.g., 702 fF). The input inductance $L_{in}$, the isolation inductance $L_{iso}$, and the isolation resistance $R_{iso}$ can remain the same from the 0dB/50Ω design. In this example, the nominal plots may be similar to the plots shown in FIG. 4. When the control circuit 302 modifies the capacitances in opposite directions, while keeping the port impedances fixed, the input-to-output power-split ratio can be adjusted to provide a selected output power-split ratio as depicted in FIG. 5.

FIG. 5 depicts a graph 500 of nominal performance plots of magnitude in decibels versus frequency in gigahertz for a programmable capacitor-inductor splitter where the port impedances are held constant while the capacitances are changed in opposite directions, in accordance with certain embodiments of the present disclosure. The graph 500 includes lines indicative of the magnitude of the power-split ratio at 502 and includes lines indicative of the phase difference of the power-split at 504.

In one or more embodiments, adjusting the capacitances of the first signal path and the second signal path to provide port 114(2) two decibels less power relative to the port 114(3) may be achieved by configuring the capacitance such that both paths have a capacitance of 884 fF. In one or more adjustments, providing the port 114(2) two decibels more power relative to the port 114(3) (i.e., a power ratio of 4 dB) may be achieved by configuring the capacitance of the first signal path to be 1.4 pF while configuring the capacitance of the second signal path to be 558 fF.

In one or more embodiments, the ports 114(2) and 114(3) may be designed to be nominally the same, such that the isolation impedance does not carry current and the splitter circuit 116 remains lossless. The power-split difference between the power at port 114(2) and the power at port 114(3) comes from different currents, hence different port impedances, which may be provided by the different capacitances.

In the graph 500, the magnitudes 502 and the phases (in degrees) are shown for different capacitance settings. In the illustrated embodiment, the control range of the power-split ratio is from zero decibels to about four decibels with the optimal flatness at two decibels. In one or more embodiments, the control range may not be exactly four decibels at a frequency of 3.6 GHz because of the impact of less-than-ideal finite return losses at the input and output. The magnitude of 0.34 dB may represent the non-flat frequency response of the extreme control corners. In one or more embodiments, a phase difference of 1.4 degrees may represent a maximum deviation at 4.2 GHz.

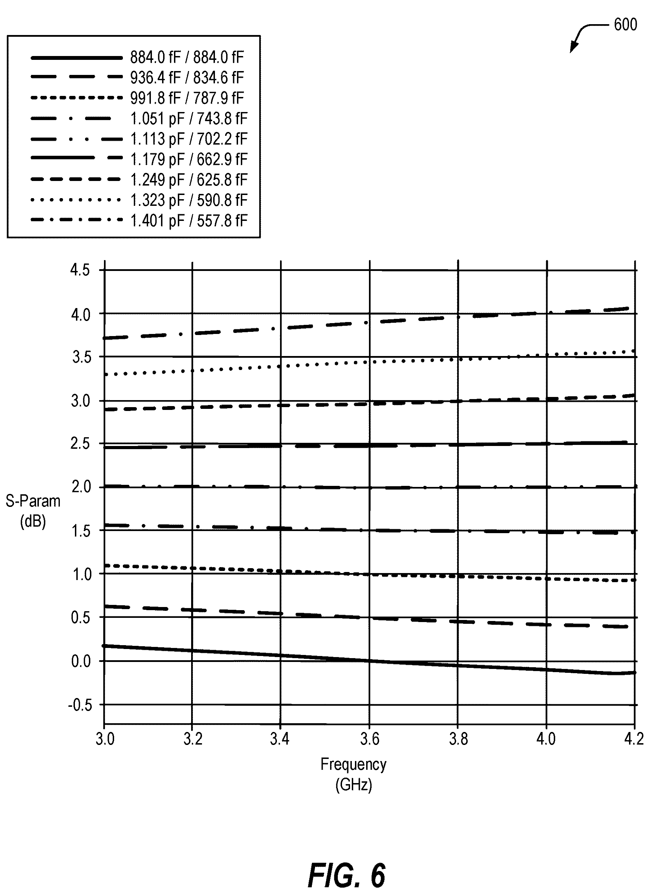

In one or more embodiments, within a prescribed control range of zero decibels to four decibels, greater resolution may be desirable. It should be understood that, depending on the adjustability of the capacitances in the first signal path and the second signal path, any number of incremental power-split ratios may be achieved. In one or more embodiments, the splitter circuit 116 may be configured to enable nine different power-split ratio states in 0.5 decibel intervals across the range. An example of the performance plots showing such decibel intervals is described below with respect to FIG. 6.

FIG. 6 depicts a graph 600 of the nominal performance plots of magnitude in decibels versus frequency in gigahertz for a programmable capacitor-inductor splitter where the programmable capacitor network enables 0.5 dB steps, in accordance with certain embodiments of the present disclosure. In the illustrated example, by adjusting the capacitance of the first signal path relative to the second signal path (in opposite directions), the splitter circuit 116 may be configured to provide nine incremental steps, as shown.

In an example, by increasing a first capacitance from 884.0 fF to 936.4 fF and decreasing a second capacitance from 884.0 fF to 834.6 fF, a power-split magnitude of approximately 0.5 dB may be achieved across a range of frequencies from 3.0 GHz to 4.2 GHz. The capacitor banks 304 may be configured to provide the granularity or size of the capacitance adjustments to achieve a selected number of steps.

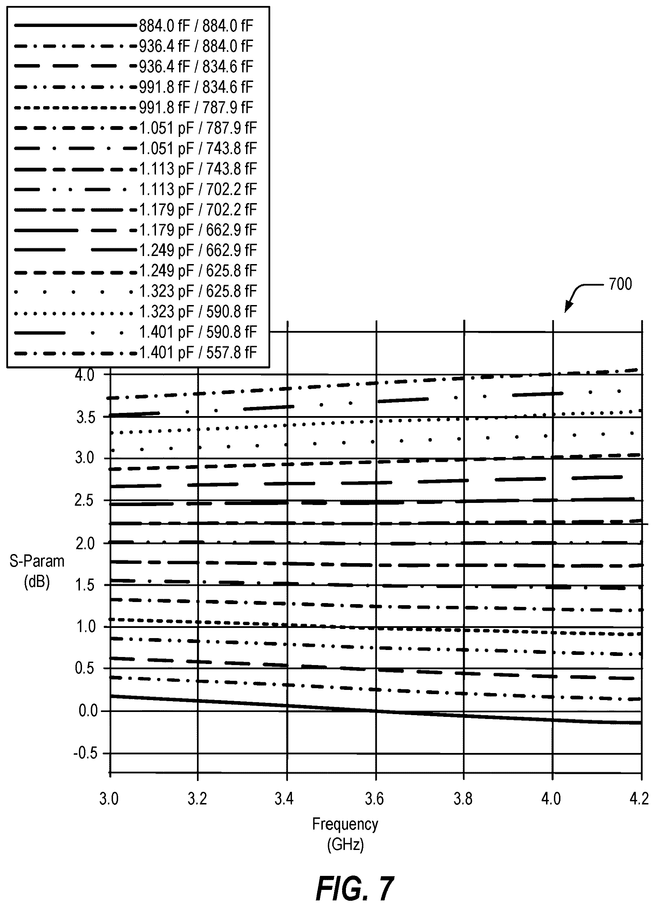

In one or more embodiments, the control circuit 302 may be configured to deviate from the opposite control strategy to produce additional power-split steps by only changing one capacitor bank 304 per step instead of both. An example of such an implementation is described below with respect to FIG. 7.

FIG. 7 depicts a graph 700 of the nominal performance plots of magnitude in decibels versus frequency in gigahertz for a programmable capacitor-inductor splitter 116 where the programmable capacitor banks 304 enable power-split radio adjustments in 0.25 dB steps, in accordance with certain embodiments of the present disclosure. The control circuit 302 may selectively activate a switch 306 of one of the capacitor banks 304(1) or 304(2) per step, instead of adjusting a switch from both. Using this technique, the splitter circuit 116 may be used to provide seventeen increments between zero and four decibels in quarter-decibel increments.

In the illustrated example, a 0.25 dB power-split ratio may be provided by changing a first capacitance from 884.0 fF to 936.4 fF while leaving a second capacitance at a nominal 884.0 fF. A half decibel power-split ratio may be provided by keeping the first capacitance at 936.4 fF while decreasing the second capacitance from 884.0 fF to 834.6 fF. A legend to the graph 700 is shown that provides capacitances for the various steps in accordance with one or more embodiments. Other capacitance values may also be used to provide the selected power-split ratios.

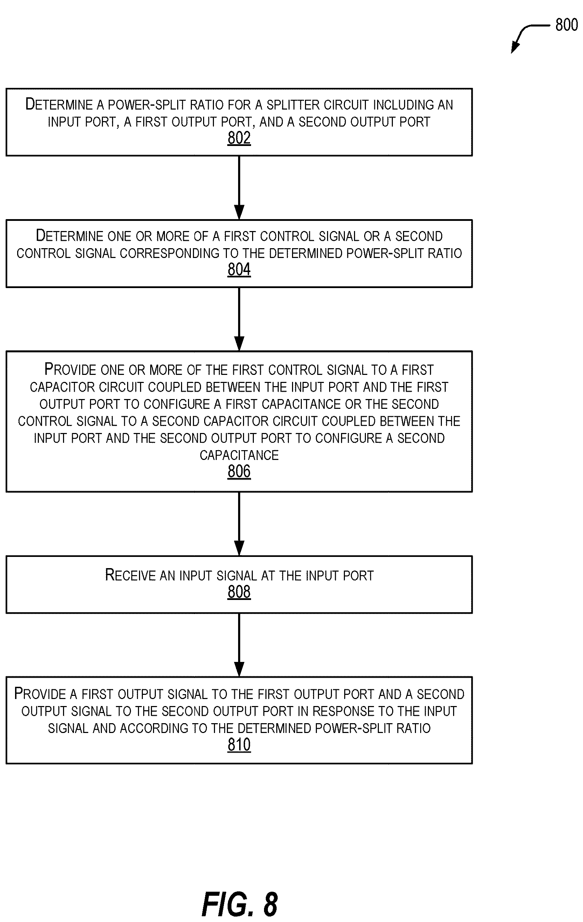

FIG. 8 depicts a flow diagram of a method 800 of splitting power provided to main and peak amplifiers of a Doherty amplifier, in accordance with certain embodiments of the present disclosure. In one or more embodiments, a splitter circuit may be programmable to provide power to the amplifiers according to a selected power-split ratio.

At 802, the method 800 may include determining a power-split ratio for a splitter circuit including an input port, a first output port, and a second output port. In one or more embodiments, the input port may be coupled to a driver circuit, such as the driver circuit 108 in FIG. 1, to receive a signal. The first output port (port 114(2)) may be coupled to a first (main) transistor 112(1) and the second output port (port 114(3)) may be coupled to a second (peaking or peak) transistor 112(2).

At 804, the method 800 may include determining one or more of a first control signal or a second control signal corresponding to the determined power-split ratio. In one or more embodiments, the first control signal may include one or more signals to configure a first capacitance associated with a first signal path between the port 114(1) and the port 114(2). The second control signal may include one or more signals to configure a second capacitance associated with a second signal path between the port 114(1) and the port 114(3).

At 806, the method 800 may include providing one or more of the first control signal to a first capacitor circuit coupled between the input port and the first output port to configure a first capacitance or the second control signal to a second capacitor circuit coupled between the input port and the second output port to configure a second capacitance. In one or more embodiments, the first control signal may be configured to control a capacitance of a variable capacitor that is coupled between the port 114(1) and the port 114(2) and the second control signal may be configured to control a capacitance of a variable capacitor that is coupled between the port 114(1) and the port 114(3). In one or more embodiments, the first control signal may be configured to selectively activate one or more switches 306 to couple associated capacitors 308 in parallel between the port 114(1) and the port 114(2) and the second control signal may be configured to selectively activate one or more switches 306 to couple associated capacitors 308 in parallel between the port 114(1) and the port 114(3). In one or more embodiments, a control circuit 302 may receive an input signal and may generate one or more of a first control signal or a second control signal in response to the received input signal. The control circuit 302 may adjust the first capacitance, the second capacitance, or both to provide a selected power-split ratio between the ports 114(2) and 114(3).

At 808, the method 800 may include receiving an input signal at the input port. In one or more embodiments, a driver circuit 108 may provide a signal to the port 114(1), which may be divided by the splitter circuit 116 to provide output signals having the programmed power-split ratio across the ports 114(2) and 114(3).

At 810, the method 800 may include providing a first output signal to the first output port and a second output signal to the second output port in response to the input signal and according to the determined power-split ratio. The splitter circuit 116 may divide the power from the input signal into two signals having a selected power-split ratio and may provide a first of the two signals to the port 114(2) and the other of the two signals to the port 114(3).

In one or more embodiments, the inductor 202 and the capacitors 206(1), 206(2), and optionally the switched capacitors 308 may provide an impedance down-converter in each signal path, including a first signal path from the port 114(1) to the port 114(2) and a second signal path from the port 114(1) to the port 114(3) (or an impedance up-converter from the ports 114(2) and 114(3) to the port 114(1)). In one or more embodiments, the capacitors 206 may be independently programmable to provide a selected capacitance, providing a selected impedance within each of the signal paths. In one or more embodiments, the capacitors 206 may provide fixed capacitances, which may be the same or different, and the capacitor banks 304 may be independently controlled to provide a selected capacitance on each of the signal paths. In one or more embodiments, one or both of the capacitor bank 304(1) or the capacitor bank 304(2) may be controlled to provide a selected capacitance, resulting in a selected power-split ratio between the port 114(2) and the port 114(3).

The present disclosure may be further understood in light of the following examples.

Example 1: A device may include a splitter circuit including a first port configured to receive an input signal; a second port configured to provide a first output signal; a third port configured to provide a second output signal; an inductor including a first terminal coupled to the first port and including a second terminal coupled to ground; a first capacitor circuit including a first terminal coupled to the first port and a second terminal coupled to the second port; a second capacitor circuit including a first terminal coupled to the first port and a second terminal coupled to the third port; and an isolation impedance coupled between the second port and the third port; and where the first capacitor circuit and the second capacitor circuit are programmable to provide a selected power-power split ratio between the first output signal and the second output signal.

Example 2: The device of Example 1, where the first capacitor circuit includes a first capacitor including a first terminal coupled to the first port and a second terminal coupled to the second port; one or more second capacitors including a first terminal and including a second terminal coupled to the second port; and one or more switches, each switch including a first terminal coupled to the first port, a second terminal coupled to the first terminal of one of the one or more second capacitors, and a control terminal responsive to a first control signal to selectively couple the one of the one or more second capacitors in parallel with the first capacitor between the first port and the second port; and the second capacitor circuit includes a first capacitor including a first terminal coupled to the first port and a second terminal coupled to the second port; one or more second capacitors including a first terminal and including a second terminal coupled to the third port; and one or more switches, each switch of the second capacitor circuit including a first terminal coupled to the first port, a second terminal coupled to the first terminal of one of the one or more second capacitors of the second capacitor circuit, and a control terminal responsive to a second control signal to selectively couple the one of the one or more second capacitors in parallel with the first capacitor of the second capacitor circuit between the first port and the third port.

Example 3: The device of any of Examples 1 or 2, further including a control circuit coupled to the first capacitor circuit and the second capacitor circuit and configured to selectively provide control signals to one or more of the first capacitor circuit or the second capacitor circuit.

Example 4: The device of Example 3, where the control circuit is configured to provide at least one of a first control signal to the first capacitor circuit or a second control signal to the second capacitor circuit to adjust a power-split ratio between the second port and the third port.

Example 5: The device of Example 3, where the control circuit is configured to provide a first control signal to increase a capacitance of the first capacitor circuit and to provide a second control signal to decrease a capacitance of the second capacitor circuit.

Example 6: The device of Example 3, where the control circuit is configured to provide a first control signal to adjust a capacitance of the first capacitor circuit while a capacitance of the second capacitor circuit remains unchanged.

Example 7: The device of Example 6, where the control circuit is configured to provide a second control signal to adjust the capacitance of the second capacitor circuit while the capacitance of the first capacitor circuit remains unchanged.

Example 8: The device of any of Examples 1-7, where the first capacitor circuit and the second capacitor circuit are programmable to enable three power-split ratios within defining two decibel steps within a range from zero decibels to four decibels.

Example 9: The device of any of Examples 1-8, where the first capacitor circuit and the second capacitor circuit are programmable to enable nine power-split ratios defining half decibel steps within a range from zero decibels to four decibels.

Example 10: The device of any of Examples 1-9, where the first capacitor circuit and the second capacitor circuit are programmable to enable seventeen power-split ratios defining quarter decibel steps within a range from zero decibels to four decibels.

Example 11: The device of any of Examples 1-9, further including an amplifier stage including a first output amplifier and a second output amplifier, the first output amplifier including an input coupled to the second port and the second output amplifier including an input coupled to the third port; and a driver circuit including an output coupled to the first port and configured to provide the input signal.

Example 12: The device of any of Examples 1-11, where the isolation impedance comprises an inductor and a resistor in series between the first output port and the second output port.

Example 13: The device of any of Examples 1-12, where the isolation impedance comprises an inductor and a resistor in parallel between the first output port and the second output port.

Example 14: A method including receiving a control signal indicative of a selected power-split ratio at a splitter circuit; and in response to the control signal: selectively configuring a first capacitance associated with a first signal path from a first port to a second port of the splitter circuit based on the control signal; selectively configuring a second capacitance associated with a second signal path from the first port to a third port of the splitter circuit based on the control signal; and where a difference between the first capacitance and the second capacitance defines the power-split ratio.

Example 15: The method of Example 14, where selectively configuring the first capacitance includes selectively activating one or more transistors to couple one or more respective capacitors of a capacitor bank in parallel between the first port and the second port.

Example 16: The method of any of Examples 14 or 15, where selectively configuring the second capacitance comprises selectively activating one or more transistors to couple one or more respective capacitors of a capacitor bank in parallel between the first port and the third port.

Example 17: The method of any of Examples14-16, where, after selectively configuring the first capacitance and the second capacitance, the method further includes: receiving a signal at the first port; providing a first output signal at the second port; and providing a second output signal at the third port; where power-split ratio between the first output signal and the second output signal corresponds to the selected power-split ratio.

Example 18: A device includes an output stage including a first amplifier with a first input and a first output and including a second amplifier with a second input and a second output; a driver circuit including an input and including an output; and a splitter circuit including: a first port coupled to the output of the driver circuit; a second port coupled to the first input of the first amplifier; a third port coupled to the second input of the second amplifier; an inductor including a first terminal coupled to the first port and including a second terminal coupled to ground; a first capacitor circuit including a first terminal coupled to the first port and a second terminal coupled to the second port; a second capacitor circuit including a first terminal coupled to the first port and a second terminal coupled to the third port; and an isolation impedance coupled between the second port and the third port; and where the first capacitor circuit and the second capacitor circuit are programmable to provide a selected power-power split ratio between the first output signal and the second output signal.

Example 19: The device of Example 18, where: the first capacitor circuit includes: a first capacitor including a first terminal coupled to the first port and a second terminal coupled to the second port; one or more second capacitors including a first terminal and including a second terminal coupled to the second port; and one or more switches, each switch including a first terminal coupled to the first port, a second terminal coupled to the first terminal of one of the one or more second capacitors, and a control terminal responsive to a first control signal to selectively couple the one of the one or more second capacitors in parallel with the first capacitor between the first port and the second port; and the second capacitor circuit includes: a first capacitor including a first terminal coupled to the first port and a second terminal coupled to the second port; one or more second capacitors including a first terminal and including a second terminal coupled to the third port; and one or more switches, each switch of the second capacitor circuit including a first terminal coupled to the first port, a second terminal coupled to the first terminal of one of the one or more second capacitors of the second capacitor circuit, and a control terminal responsive to a second control signal to selectively couple the one of the one or more second capacitors in parallel with the first capacitor of the second capacitor circuit between the first port and the third port.

Example 20: The device of any of Examples 18 or 19, further including a control circuit coupled to the first capacitor circuit and the second capacitor circuit and configured to selectively provide control signals to selectively adjust one or more of a first capacitance associated with the first capacitor circuit or a second capacitance associated with the second capacitor circuit.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

**Claims**

1. A device comprises:
   a splitter circuit comprising:

   a first port configured to receive an input signal;
   a second port configured to provide a first output signal;
   a third port configured to provide a second output signal;
   an inductor including a first terminal coupled to the first port and including a second terminal coupled to ground;
   a first capacitor circuit including a first terminal coupled to the first port and a second terminal coupled to the second port;
   a second capacitor circuit including a first terminal coupled to the first port and a second terminal coupled to the third port; and
   an isolation impedance coupled between the second port and the third port; and
   wherein the first capacitor circuit and the second capacitor circuit are programmable to provide a selected power-power split ratio between the first output signal and the second output signal.

2. The device of claim 1, wherein:

   the first capacitor circuit comprises:

   a first capacitor including a first terminal coupled to the first port and a second terminal coupled to the second port;
   one or more second capacitors including a first terminal and including a second terminal coupled to the second port; and
   one or more switches, each switch including a first terminal coupled to the first port, a second terminal coupled to the first terminal of one of the one or more second capacitors, and a control terminal responsive to a first control signal to selectively couple the one of the one or more second capacitors in parallel with the first capacitor between the first port and the second port; and

   the second capacitor circuit comprises:

   a first capacitor including a first terminal coupled to the first port and a second terminal coupled to the second port;
   one or more second capacitors including a first terminal and including a second terminal coupled to the third port; and
   one or more switches, each switch of the second capacitor circuit including a first terminal coupled to the first port, a second terminal coupled to the first terminal of one of the one or more second capacitors of the second capacitor circuit, and a control terminal responsive to a second control signal to selectively couple the one of the one or more second capacitors in parallel with the first capacitor of the second capacitor circuit between the first port and the third port.

3. The device of claim 1 or 2, further comprising a control circuit coupled to the first capacitor circuit and the second capacitor circuit and configured to selectively provide control signals to one or more of the first capacitor circuit or the second capacitor circuit.

4. The device of claim 3, wherein the control circuit is configured to provide at least one of a first control signal to the first capacitor circuit or a second control signal to the second capacitor circuit to adjust a power-split ratio between the second port and the third port.

5. The device of claim 3, wherein the control circuit is configured to provide a first control signal to increase a capacitance of the first capacitor circuit and to provide a second control signal to decrease a capacitance of the second capacitor circuit.

6. The device of claim 3, wherein the control circuit is configured to provide a first control signal to adjust a capacitance of the first capacitor circuit while a capacitance of the second capacitor circuit remains unchanged.

7. The device of claim 6, wherein the control circuit is configured to provide a second control signal to adjust the capacitance of the second capacitor circuit while the capacitance of the first capacitor circuit remains unchanged.

8. The device of any preceding claim, wherein the first capacitor circuit and the second capacitor circuit are programmable to enable three power-split ratios within defining two decibel steps within a range from zero decibels to four decibels.

9. The device of any of claims 1 to 7, wherein the first capacitor circuit and the second capacitor circuit are programmable to enable nine power-split ratios defining half decibel steps within a range from zero decibels to four decibels.

10. The device of any of claims 1 to 7, wherein the first capacitor circuit and the second capacitor circuit are programmable to enable seventeen power-split ratios defining quarter decibel steps within a range from zero decibels to four decibels.

11. The device of any preceding claim, further comprising:

an amplifier stage including a first output amplifier and a second output amplifier, the first output amplifier including an input coupled to the second port and the second output amplifier including an input coupled to the third port; and
a driver circuit including an output coupled to the first port and configured to provide the input signal.

12. The device of any preceding claim, wherein the isolation impedance comprises an inductor and a resistor in series between the first output port and the second output port.

13. The device of any of claims 1 to 12, wherein the isolation impedance comprises an inductor and a resistor in parallel between the first output port and the second output port.

14. A method comprising:

receiving a control signal indicative of a selected power-split ratio at a splitter circuit; and
in response to the control signal:

selectively configuring a first capacitance associated with a first signal path from a first port to a second port of the splitter circuit based on the control signal;
selectively configuring a second capacitance associated with a second signal path from the first port to a third port of the splitter circuit based on the control signal; and

wherein a difference between the first capacitance and the second capacitance defines the power-split ratio.

15. The method of claim 14, wherein at least one of: selectively configuring the first capacitance comprises selectively activating one or more transistors to couple one or more respective capacitors of a capacitor bank in parallel between the first port and the second port; and selectively configuring the second capacitance comprises selectively activating one or more transistors to couple one or more respective capacitors of a capacitor bank in parallel between the first port and the third port.

100

PRE-DRIVER
118

DOHERTY POWER AMPLIFIER
104

SPLITTER CIRCUIT
102

120

122

108

116

114(1)

114(2)

114(3)

110

112(1)

COMBINING
NODE
106

113

112(2)

FIG. 1

200

SPLITTER CIRCUIT
116

206(1)   207   114(2)

P2, $Z_0$

114(1)

205

P1, $Z_0$

202

204

208

210

206(2)

211

P3, $Z_0$

114(3)

*FIG. 2A*

220

SPLITTER CIRCUIT
116

206(1)   207   114(2)

P2, $Z_0$

114(1)

205

P1, $Z_0$

202

204

210

206(2)

211

208

P3, $Z_0$

114(3)

*FIG. 2B*

*FIG. 3*

*FIG. 4*

EP 4 708 688 A1

FIG. 5

FIG. 6

FIG. 7

800

```
┌─────────────────────────────────────────────────────────────┐
│  DETERMINE A POWER-SPLIT RATIO FOR A SPLITTER CIRCUIT         │
│  INCLUDING AN INPUT PORT, A FIRST OUTPUT PORT, AND A          │
│  SECOND OUTPUT PORT                                          │
│                         802                                  │
└─────────────────────────────────────────────────────────────┘
                              │
                              ▼
┌─────────────────────────────────────────────────────────────┐
│  DETERMINE ONE OR MORE OF A FIRST CONTROL SIGNAL OR A         │
│  SECOND CONTROL SIGNAL CORRESPONDING TO THE DETERMINED        │
│  POWER-SPLIT RATIO                                           │
│                         804                                  │
└─────────────────────────────────────────────────────────────┘
                              │
                              ▼
┌─────────────────────────────────────────────────────────────┐
│  PROVIDE ONE OR MORE OF THE FIRST CONTROL SIGNAL TO A         │
│  FIRST CAPACITOR CIRCUIT COUPLED BETWEEN THE INPUT PORT       │
│  AND THE FIRST OUTPUT PORT TO CONFIGURE A FIRST               │
│  CAPACITANCE OR THE SECOND CONTROL SIGNAL TO A SECOND         │
│  CAPACITOR CIRCUIT COUPLED BETWEEN THE INPUT PORT AND THE     │
│  SECOND OUTPUT PORT TO CONFIGURE A SECOND CAPACITANCE         │
│                         806                                  │
└─────────────────────────────────────────────────────────────┘
                              │
                              ▼
┌─────────────────────────────────────────────────────────────┐
│  RECEIVE AN INPUT SIGNAL AT THE INPUT PORT                    │
│                         808                                  │
└─────────────────────────────────────────────────────────────┘
                              │
                              ▼
┌─────────────────────────────────────────────────────────────┐
│  PROVIDE A FIRST OUTPUT SIGNAL TO THE FIRST OUTPUT PORT AND   │
│  A SECOND OUTPUT SIGNAL TO THE SECOND OUTPUT PORT IN          │
│  RESPONSE TO THE INPUT SIGNAL AND ACCORDING TO THE            │
│  DETERMINED POWER-SPLIT RATIO                                │
│                         810                                  │
└─────────────────────────────────────────────────────────────┘
```

*FIG. 8*

| | Europäisches Patentamt |
|---|---|
| | European Patent Office |
| | Office européen des brevets |

## EUROPEAN SEARCH REPORT

**Application Number**

EP 25 19 9389

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LV GUANSHENG ET AL: "A Highly Linear GaN MMIC Doherty Power Amplifier Based on Phase Mismatch Induced AM-PM Compensation", IEEE TRANSACTIONS ON MICROWAVE THEORY AND TECHNIQUES, vol. 70, no. 2, 28 February 2022 (2022-02-28), pages 1334-1348, XP093358661, USA ISSN: 0018-9480 * Section III.B; figures 13, 21; table 1 * | 1-15 | INV.<br>H03H7/01<br>H03H7/38<br>H03H7/48<br>H03F1/02<br>H03F3/21<br><br>ADD.<br>H03H7/06 |
| A | US 2019/214961 A1 (HOSAGAVI PUTTARAJU ANURANJAN [US] ET AL) 11 July 2019 (2019-07-11) * paragraphs [0038] - [0047]; figure 6; tables 1A, 1B, 3 * | 1-3,5 | |
| A | MUNG STEVE W. ET AL: "Compact tunable lumped-element Wilkinson power divider with high isolation", MICROWAVE AND OPTICAL TECHNOLOGY LETTERS, [Online] vol. 53, no. 2, 15 December 2010 (2010-12-15), pages 288-290, XP093357687, US ISSN: 0895-2477, DOI: 10.1002/mop.25717 Retrieved from the Internet: URL:https://onlinelibrary.wiley.com/doi/10.1002/mop.25717> [retrieved on 2026-01-28] * Sections 2 and 3; figures 1, 4, 5 * | 1-10, 12-15 | TECHNICAL FIELDS SEARCHED (IPC)<br><br>H03H<br>H03F |

-/--

The present search report has been drawn up for all claims

| Place of search | Date of completion of the search | Examiner |
|---|---|---|
| Munich | 28 January 2026 | Helmut, Dennis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 25 19 9389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 2010 0004440 A (UNIV KWANGWOON IND ACAD COLLAB [KR]) 13 January 2010 (2010-01-13)<br>* the whole document *<br>----- | 12,13 | |

TECHNICAL FIELDS
SEARCHED     (IPC)

The present search report has been drawn up for all claims

| Place of search | Date of completion of the search | Examiner |
|---|---|---|
| Munich | 28 January 2026 | Helmut, Dennis |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

page 2 of 2

## ANNEX TO THE EUROPEAN SEARCH REPORT
## ON EUROPEAN PATENT APPLICATION NO.

EP 25 19 9389

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2026

| Patent document cited in search report | Publication date | Patent family member(s) | Publication date |
|---|---|---|---|
| US 2019214961 A1 | 11-07-2019 | US 2019214961 A1<br>US 2021265968 A1<br>US 2023361748 A1 | 11-07-2019<br>26-08-2021<br>09-11-2023 |
| KR 20100004440 A | 13-01-2010 | NONE | |

EPO FORM P0459

For more details about this annex : see Official Journal of the European Patent Office, No. 12/82